# EUROPEAN PATENT APPLICATION

(11) **EP 4 697 889 A1**
(43) Date of publication of application: **18.02.2026**
(21) Application number: 25171638.7
(22) Date of filing: 22.04.2025
(51) Int. Cl.: H10D 30/67, H10B 12/00

(54) **SEMICONDUCTOR DEVICE AND METHOD OF MANUFACTURING THE SAME**

(30) Priority: 16.08.2024 KR 20240110011
(71) Applicant: Samsung Electronics Co., Ltd., Suwon-si, Gyeonggi-do 16677 (KR)
(72) Inventor: JUNG, Kyooho, 16678 Suwon-si (KR); CHA, Youngkwan, 16678 Suwon-si (KR); KIM, Sangwook, 16678 Suwon-si (KR); YANG, Jeeeun, 16678 Suwon-si (KR)
(74) Representative: Elkington and Fife LLP

(57) **Abstract**

Provided are a semiconductor device and a manufacturing method thereof. The semiconductor device includes an oxide semiconductor layer including a plurality of metals, wherein, with respect to the plurality of metals, a content of indium (In) is less than 50 at%, and a content of zinc (Zn) is 0 at%, a gate electrode being apart from the oxide semiconductor layer, a gate insulating layer being between the oxide semiconductor layer and the gate electrode, and a first electrode and a second electrode on the oxide semiconductor layer and being apart from each other with the gate electrode interposed therebetween.

## Description

### FIELD OF THE INVENTION

The disclosure relates to semiconductor devices, and more particularly, to semiconductor devices including an oxide semiconductor and methods of manufacturing the semiconductor device.

### BACKGROUND OF THE INVENTION

A transistor is a semiconductor device which performs the function of electric switching and is used in various integrated circuit (IC) devices including a memory, a driving IC, a logic device, etc. To increase the degree of integration of IC devices, the space occupied by transistors included in IC devices has been reduced, and research is being conducted to decrease the size of transistors while maintaining their performance.

Oxide semiconductor devices, which are transparent semiconductor devices characterized by a wide band gap of 3.0 eV or more, have been studied for years. Oxide semiconductor devices used in large-area display driving devices have good characteristics, such as a low off-current, a high on/off ratio, etc. Researches have been conducted to use the oxide semiconductor device with the advantages described above as a memory or a logic device.

When an oxide semiconductor device is used as a memory or a logic device, the oxide semiconductor device needs to operate stably under heat applied during a back end of line, e.g., at 500 °C.

### SUMMARY OF THE INVENTION

Provided are semiconductor devices with improved thermal stability and/or manufacturing methods thereof.

Additional aspects will be set forth in part in the description which follows and, in part, will be apparent from the description, or may be learned by practice of the presented example embodiments of the disclosure.

According to an example embodiment of the disclosure, a semiconductor device includes an oxide semiconductor layer including a plurality of metals, wherein, with respect to the plurality of metals, a content of indium (In) is less than 50 at%, and a content of zinc (Zn) is 0 at%, a gate electrode being apart from the oxide semiconductor layer, a gate insulating layer being between the oxide semiconductor layer and the gate electrode, and a first electrode and a second electrode on the oxide semiconductor layer and being apart from each other with the gate electrode interposed therebetween.

The oxide semiconductor layer may further include at least one of gallium (Ga), tin (Sn), cadmium (Cd), aluminum (Al), germanium (Ge), and hafnium (Hf).

The content of indium (In) with respect to the plurality of metals may be 10 at% or more.

The oxide semiconductor layer may further include gallium (Ga), a content of gallium (Ga) may be greater than the content of indium (In).

The oxide semiconductor layer may include only InGaO, and a content of gallium (Ga) may be 50 at% or more.

The oxide semiconductor layer may maintain an amorphous phase at a temperature from about 450 °C to about 700 °C.

The first electrode, the oxide semiconductor layer, and the second electrode may be in sequence in a direction perpendicular to a surface of the first electrode.

The oxide semiconductor layer may include, in a cross-sectional view perpendicular to the surface of the first electrode, a first area extending in a direction parallel with the surface of the first electrode and a second area extending from the first electrode towards the second electrode.

The semiconductor device may further include a capacitor electrically connected to the oxide semiconductor layer, wherein the first electrode may be a component of a bit line, and the gate electrode may be a component of a word line.

The second electrode may be an electrode of the capacitor.

The semiconductor device may further include a metal nitride layer being between the oxide semiconductor layer and at least one of the first electrode and the second electrode, and an oxide layer being between the metal nitride layer and the oxide semiconductor layer, the oxide layer being an indium (In) based oxide layer.

The metal nitride layer may be in direct contact with at least one of the first electrode and the second electrode.

The oxide layer may be in direct contact with at least one of the oxide semiconductor layer and the metal nitride layer.

The oxide layer may include at least one metal included in the oxide semiconductor layer.

The oxide layer may include indium (In) and a content of indium (In) with respect to a plurality of metals included in the oxide layer may be 50 at% or more.

The metal nitride layer may include a metal different from a first metal included in the first electrode, a second metal included in the second electrode, and the plurality of metals included in the oxide semiconductor layer.

The metal nitride layer may include at least one of titanium (Ti), molybdenum (Mo), niobium (Nb), and tantalum (Ta).

A thickness of the oxide layer may be 5 nm or less.

A thickness of the metal nitride layer may be 10 nm or less.

The metal nitride layer may include a first metal nitride layer arranged between the first electrode and the oxide semiconductor layer and a second metal nitride layer arranged between the second electrode and the oxide semiconductor layer, and the oxide layer may include a first oxide layer arranged between the first metal nitride layer and the oxide semiconductor layer and a second oxide layer arranged between the second metal nitride layer and the oxide semiconductor layer.

According to an example embodiment of the disclosure, a method of manufacturing a semiconductor device includes forming a first insulating layer on a first electrode, the first insulating layer including an opening exposing the first electrode, sequentially forming a first metal nitride layer and a first oxide layer on the first electrode exposed by the opening, forming an oxide semiconductor layer on the oxide layer and the first insulating layer, the oxide semiconductor layer including a plurality of metals, wherein, with respect to the plurality of metals, a content of indium (In) is less than 50 at%, and a content of zinc (Zn) is 0 at%, sequentially forming a gate insulating layer and a gate electrode on a first surface of the oxide semiconductor layer, and forming a second electrode on a second surface of the oxide semiconductor layer, which is different from the first surface of the oxide semiconductor layer.

The forming of the gate insulating layer and the gate electrode may include etching the gate insulating layer and the gate electrode in a direction to an upper portion of the first insulating layer to expose a surface of the oxide semiconductor layer such that the gate insulating layer is divided into a first gate insulating layer and a second gate insulating layer and the gate electrode is divided into a first gate electrode and a second gate electrode, surface of the oxide semiconductor layer being parallel with the surface of the first electrode, and partially etching the first gate electrode and the second gate electrode such that heights of upper surfaces of the first gate electrode and the second electrode from the first electrode are lower than heights of upper surfaces of the first gate insulating layer and the second gate insulating layer from the first electrode, respectively.

The forming of the second electrode may include forming a second oxide layer on the second surface of the oxide semiconductor layer, forming a second metal nitride layer on the second oxide layer, and forming the second electrode on the second metal nitride layer.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a diagram of a semiconductor device according to an example embodiment;
FIG. 2 is a diagram of a semiconductor device further including a metal nitride layer between an oxide semiconductor layer and a metal layer;
FIG. 3A illustrates a graph showing IV characteristics after performing heat treatment at 300 °C on a transistor including a channel layer formed of Indium gallium zinc oxide (IGZO_ and an electrode formed of W, as Comparative Example;
FIG. 3B illustrates a graph showing IV characteristics after performing heat treatment at 500 °C on a transistor including a channel layer formed of IGZO and an electrode formed of W, as Comparative Example;
FIG. 4 illustrates a graph showing IV characteristics after performing heat treatment at 500 °C on a transistor including a channel layer formed of Indium Gallium Oxide (IGO) (In content of 57 at%) and an electrode formed of W, as Comparative Example;
FIG. 5 illustrates a graph showing IV characteristics after performing heat treatment at 500 °C on a transistor including a channel layer formed of IGO (In content of 34 at%) and an electrode formed of W, as Example Embodiment 1;
FIG. 6 illustrates a graph showing IV characteristics after performing heat treatment at 500 °C on a transistor including a channel layer formed of IGO (In content of 34 at%), an electrode formed of W, and a layer formed of InO and a layer formed of InO between the channel layer and the electrode, as Example Embodiment 2;
FIG. 7 is a diagram of a semiconductor device according to an example embodiment;
FIG. 8 is a diagram of a semiconductor device according to another example embodiment;
FIG. 9 is a diagram of a semiconductor device according to another example embodiment;
FIG. 10 is a diagram of a semiconductor device according to another example embodiment;
FIG. 11 is a diagram of a semiconductor device according to another example embodiment;
FIG. 12 is a flowchart of a method of manufacturing a semiconductor device, according to an example embodiment;
FIGS. 13 to 20 are cross-sectional views sequentially illustrating the method of manufacturing the semiconductor device of FIG. 10;
FIG. 21 is a perspective view illustrating an example of a schematic structure of a vertically stacked memory device according to an example embodiment;
FIG. 22 is a perspective view illustrating an example of a schematic structure of a vertically stacked memory device according to another example embodiment;
FIG. 23 is a block diagram illustrating an electronic system according to an example embodiment; and
FIG. 24 is a block diagram illustrating an electronic system according to an example embodiment.

### DETAILED DESCRIPTION

Reference will now be made in detail to some example embodiments, examples of which are illustrated in the accompanying drawings, wherein like reference numerals refer to like elements throughout. In this regard, the presented example embodiments may have different forms and should not be construed as being limited to the descriptions set forth herein. Accordingly, the presented example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a semiconductor device including a multi-layer structure according to various example embodiments is described in detail with reference to the attached drawings. In the drawings, like reference numerals in the drawings denote like elements, and sizes of components in the drawings may be exaggerated for clarity and convenience of explanation.

An expression used in the singular encompasses the expression of the plural, unless it has a clearly different meaning in the context. When a portion "includes" a component, another component may be further included, rather than excluding the existence of the other component, unless otherwise described. Sizes or thicknesses of components in the drawings may be arbitrarily exaggerated for convenience of explanation. Further, when a certain material layer is described as being arranged on a substrate or another layer, the material layer may be in contact with the other layer, or there may be a third layer between the material layer and the other layer. In the presented example embodiments, materials constituting each layer are provided merely as an example, and other materials may also be used.

Moreover, the terms "part," "module," etc. refer to a unit processing at least one function or operation, and may be implemented by a hardware, a software, or a combination thereof.

The particular implementations shown and described herein are illustrative examples of some example embodiments and are not intended to otherwise limit the scope of example embodiments in any way. For the sake of brevity, conventional electronics, control systems, software development and/or other functional aspects of the systems may not be described in detail.

Furthermore, the connecting lines, or connectors shown in the various figures presented are intended to represent example functional relations and/or physical or logical couplings between the various elements. It should be noted that many alternative or additional functional relations, physical connections or logical connections may be present in a practical device.

The use of the terms "a" and "an" and "the" and similar referents in the context of describing the example embodiments (especially in the context of the following claims) are to be construed to cover both the singular and the plural.

The expression such as "at least" used to list elements is intended to limit a list of entire elements, rather than individual elements in the list. For example, expressions such as "at least one of A, B, and C" or "at least one selected from the group consisting of A, B, and C" may be interpreted as only A, only B, only C, or a combination of two or more of A, B, and C, e.g., ABC, AB, BC, and AC.

When the terms such as "about" or "substantially" are used in relation to numerical values, the relevant numerical value may be construed as including a manufacturing or operation deviation (e.g., ±10 %) of the stated numerical value. In addition, when the expressions such as "generally" and "substantially" are used in relation to a geometric shape, the geometric precision may not be required, and the intention is that the degree of tolerance regarding the shape is within the scope of embodiments of the disclosure. Moreover, regardless of whether a numerical value of a shape is limited by using "about" or "substantially", such numerical value or shape should be understood as including a manufacturing or operation deviation (e.g., ±10 %) of the stated numerical value.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

While such terms as "first," "second," etc., may be used to describe various components, such components must not be limited to the above terms. The above terms are used only to distinguish one component from another.

The use of any and all examples, or example language provided herein is intended merely to better illuminate technical ideas and does not pose a limitation on the scope of example embodiments unless otherwise claimed.

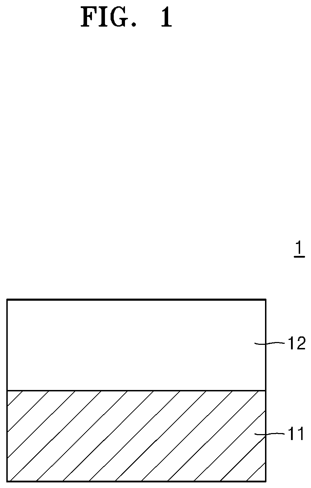

FIG. 1 is a diagram of a semiconductor device 1 according to an example embodiment. The semiconductor device 1 of FIG. 1 may be a component of a transistor or a memory cell. Referring to FIG. 1, the semiconductor device 1 may include an oxide semiconductor layer 11 and a metal layer 12 arranged on the oxide semiconductor layer 11.

The oxide semiconductor layer 11 according to an example embodiment may include a plurality of metals. The oxide semiconductor layer 11 according to an example embodiment may include Groups 12, 13, and 14 metals, such as indium (In), gallium (Ga), tin (Sn), cadmium (Cd), aluminum (Al), germanium (Ge), or hafnium (Hf), and an oxide of a material selected from combinations thereof. For example, the oxide semiconductor layer 11 may have a single-layer structure or a multi-layer structure. The thickness of the oxide semiconductor layer 11 may be about 10 nm or less, about 8 nm or less, or about 7 nm or less. When the semiconductor device 1 is a component of a memory cell or a transistor, the oxide semiconductor layer 11 may be a channel layer.

As In needs low bond dissociation energy with respect to oxygen, oxygen vacancy may be easily formed. Accordingly, charge carrier concentration of the oxide semiconductor layer 11 may be increased, and formation of electronic conduction pathway through the 5s orbital may be facilitated. However, as In is unstable to heat, when In is included dominantly in the oxide semiconductor layer 11, the electrical characteristics of the oxide semiconductor layer 11 may change according to temperature. For example, when the heat of about 400 °C of higher is applied to the oxide semiconductor layer 11, In may be diffused or dispersed in the oxide semiconductor layer 11, and accordingly, the oxide semiconductor layer 11 may lose semiconductor characteristics and have conductor characteristics.

The oxide semiconductor layer 11 according to an example embodiment may include a plurality of metals including In; however, the content of In with respect to the plurality of metals may be less than about 50 at%, about 40 at% or less, about 35 at% or less, about 10 at% or less, or about 5 at% or more.

The oxide semiconductor layer 11 according to an example embodiment may not include zinc (Zn). Zn is a thermally unstable material. The recrystallization temperature of Zn is 50 °C or less. Zn may be recrystallized by heat of about 200 °C to about 300 °C, and the electrical characteristics thereof may change. As the oxide semiconductor layer 11 according to an example embodiment does not include Zn, even when heat of about 400 °C to about 500 °C is applied, the semiconductor characteristics thereof may be maintained.

As the oxide semiconductor layer 11 does not include Zn, which is unstable to heat, and include a small amount of In, even when heat of about 400 °C or more is applied thereto, the crystallization may not occur, and the amorphous phase may be maintained. Accordingly, the oxide semiconductor layer 11 according to an example embodiment may have an amorphous phase, and even when heat of about 450 °C to about 700 °C or heat of about 500 °C to about 700 °C is applied, the amorphous phase may be maintained.

The oxide semiconductor layer 11 according to an example embodiment may include In and Ga. The content of Ga may be greater than the content of In. The content of Ga may be about 50 at% or more. For example, the oxide semiconductor layer may include InGaO at the content of about 50 at%.

The thickness of the oxide semiconductor layer 11 may be about 10 nm or less, about 8 nm or less, or about 7 nm or less.

The semiconductor device 1 according to an example embodiment may include the metal layer 12 arranged on the oxide semiconductor layer 11. The metal layer 12 may only include metal. The metal layer 12 may include at least one of tungsten (W), cobalt (Co), nickel (Ni), iron (Fe), titanium (Ti), molybdenum (Mo), chrome (Cr), zirconium (Zr), hafnium (Hf), niobium (Nb), tantalum (Ta), silver (Ag), gold (Au), aluminum (Al), copper (Cu), tin (Sn), vanadium (V), ruthenium (Ru), platinum (Pt), zinc (Zn), and magnesium (Mg).

The thickness of the metal layer 12 may be about 20 nm or less. For example, the thickness of the metal layer 12 may be about 1 nm or more, about 3 nm or more, or about 5 nm or more, and may be about 15 nm or less, about 10 nm or less, or about 7 nm or less.

When the semiconductor device 1 is a component of a transistor, the metal layer 12 may be a source electrode or a drain electrode. When the semiconductor device 1 is a component of a memory cell, the metal layer 12 may be a partial area of a bit line.

As the oxide semiconductor layer 11 according to an example embodiment does not include Zn and includes a small amount of In, the semiconductor characteristics thereof may be maintained even when heat of about 450 °C to about 700 °C or about 500 °C to about 700 °C is applied thereto. Accordingly, the thermal stability of the semiconductor device 1 according to an example embodiment may be improved.

When the semiconductor device 1 according to an example embodiment operates as a transistor, the threshold voltage of the semiconductor device 1 may be about -1 V to about +1 V. In addition, the on/off current ratio of the semiconductor device 1 may be 3E4 (i.e., 3×10⁴) or more.

The semiconductor device according to an example embodiment may further include an additional layer between the oxide semiconductor layer 11 and the metal layer 12 to improve electrical characteristics.

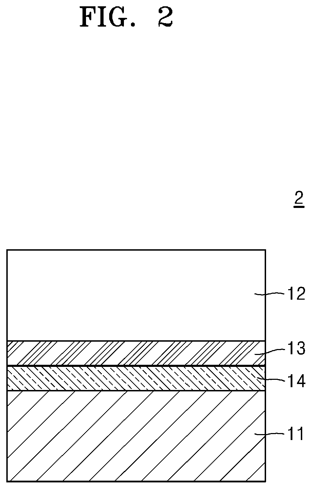

FIG. 2 is a diagram illustrating a semiconductor device 2 further including a metal nitride layer 13 and an oxide layer 14 between the oxide semiconductor layer 11 and the metal layer 12. When comparing FIGS. 1 and 2, the semiconductor device 2 of FIG. 2 may further include the metal nitride layer 13 between the oxide semiconductor layer 11 and the metal layer 12. The metal nitride layer 13 may be in direct contact with the metal layer 12. Due to the great binding force of nitrogen, the metal nitride layer 13 may reduce or prevent interdiffusion between the oxide semiconductor layer 11 and the metal layer 12.

The metal nitride layer 13 may be a conductive material and may include metal. The metal included in the metal nitride layer 13 may be different from at least one of the metal included in the oxide semiconductor layer 11 and metal included in the metal layer 12. For example, the metal nitride layer 13 may be nitride including at least one of Ti, Mo, Nb, and Ta. When the metal layer 12 includes W, the metal nitride layer 13 may include TiN.

The thickness of the metal nitride layer 13 may be less than the thickness of the metal layer 12. For example, the thickness of the metal nitride layer 13 may be less than or equal to about 1/2 of th½hickness of the metal layer 12. The thickness of the metal nitride layer 13 may be about 10 nm or less. The thickness of the metal nitride layer 13 may be about 0.1 nm or more, about 0.3 nm or more, about 0.5 nm or more, about 0.8 nm or more, or about 1 nm or more, and may be about 8 nm or less, about 7 nm or less, about 6 nm or less, or about 5 nm or less. For example, the thickness of the metal nitride layer 13 may be about 0.1 nm to about 10 nm.

The semiconductor device 2 according to an example embodiment may further include the oxide layer 14 arranged between the oxide semiconductor layer 11 and the metal nitride layer 13. The oxide layer 14 may be in direct contact with at least one of the metal nitride layer 13 and the oxide semiconductor layer 11.

The oxide layer 14 may include an oxide having a dominant In content (e.g., an In based oxide layer). The dominant In content may mean that the content of In with respect to metals included in the oxide layer 14 is the greatest. For example, the oxide layer 14 may include at least about 50 at% of In among metals included in the oxide layer 14. In some example embodiments, the oxide layer 14 may be an indium oxide which only includes In.

The oxide layer 14 may further include other metals in addition to In. The oxide layer 14 may include at least one metal included in the oxide semiconductor layer. For example, the kinds of metals included in the oxide layer 14 may be identical to those included in the oxide semiconductor layer 11. For example, in addition to In, the oxide layer 14 may include at least one of Ga, Sn, Cd, Al, Ge, and Hf.

The thickness of the oxide layer 14 may be less than the thickness of the oxide semiconductor layer 11. For example, the thickness of the oxide layer 14 may be less than or equal to about 1/2 of the thickness of the oxide semiconductor layer 11. The thickness of the oxide layer 14 may be 5 nm or less. The thickness of the oxide layer 14 may be about 0.1 nm or more, about 0.5 nm or more, or about 1 nm or more, and may be about 3 nm or less, about 3.5 nm or less, about 4 nm or less, or about 5 nm or less. In some example embodiments(high , the thickness of the oxide layer 14 may be about 0.5 nm to about 5 nm.

An interface between the oxide layer 14 and the oxide semiconductor layer 11 may be unclear. For example, the oxide layer 14 may be formed as a part of the oxide semiconductor layer 11. When forming the oxide semiconductor layer 11, the oxide layer 14 may be formed by increasing the In content, and the oxide semiconductor layer 11 may be formed by decreasing the In content.

The oxide semiconductor layer 11 of FIG. 1 may be applied as the oxide semiconductor layer 11 of FIG. 2. However, example embodiments are not limited thereto. The oxide semiconductor layer 11 of FIG. 2 may include at least 50 at% of In and may include Zn.

The metal nitride layer 13 may reduce or prevent material diffusion between the oxide semiconductor layer 11 and the metal layer 12 but may increase contact resistance. However, by arranging the oxide layer 14 with high In content, the contact resistance between the oxide semiconductor layer 11 and the metal nitride layer 13 may be improved.

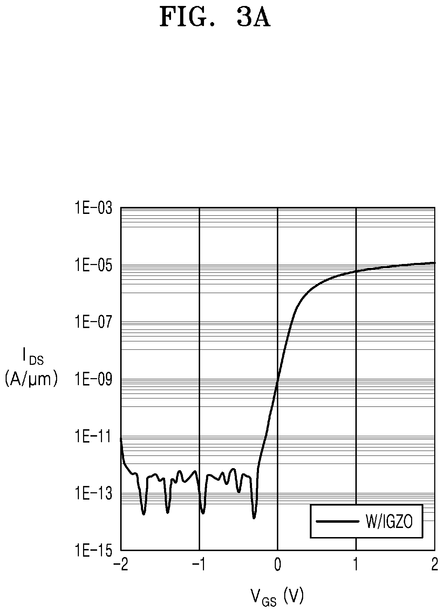

FIG. 3A illustrates a graph showing IV characteristics after performing heat treatment at 300 °C on a transistor including a channel layer formed of Indium gallium zinc oxide (IGZO) and an electrode formed of W, as Comparative Example. Referring to FIG. 3A, the transistor according to Comparative Example may have a negative threshold voltage. In this regard, the threshold voltage may refer to a minimum voltage when a current of 1E-10A/µm or more flows at the channel layer.

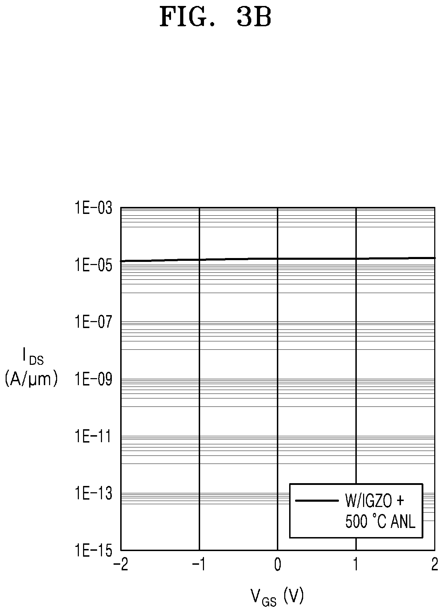

FIG. 3B illustrates a graph showing IV characteristics after performing heat treatment at 500 °C on a transistor including a channel layer formed of IGZO and an electrode formed of W, as Comparative Example. Referring to FIG. 3B, when the transistor according to Comparative Example is heat-treated at 500 °C, the channel layer may lose semiconductor characteristics and may not be turned off.

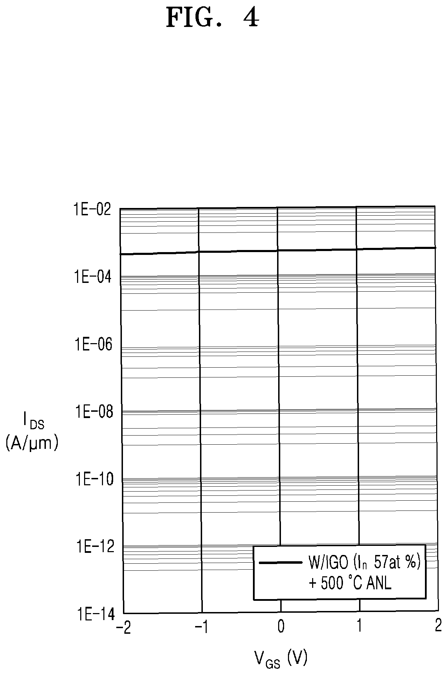

FIG. 4 illustrates a graph showing IV characteristics after performing heat treatment at 500 °C on a transistor including a channel layer formed of Indium Gallium Oxide (IGO) (In 57 at%) and an electrode formed of W, as Comparative Example. Although the channel layer applied to FIG. 4 does not include Zn, the In content is about 57 at%. Referring to FIG. 4, when the transistor according to Comparative Example is heat-treated at 500 °C, the channel layer may lose semiconductor characteristics and may not be turned off.

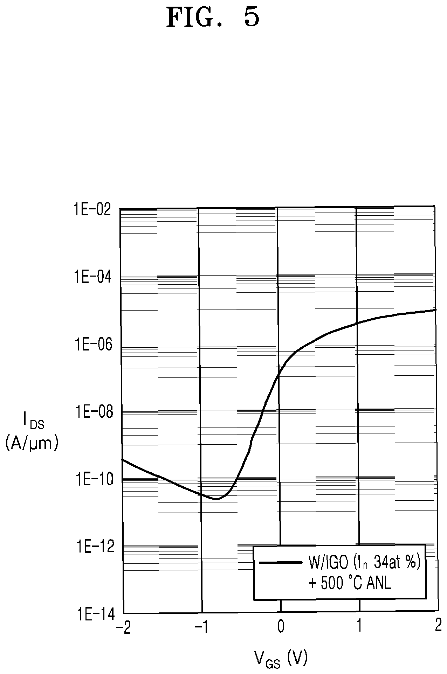

FIG. 5 illustrates a graph showing IV characteristics after performing heat treatment at 500 °C on a transistor including a channel layer formed of IGO (In 34 at%) and an electrode formed of W, as Example Embodiment 1. The channel layer applied to FIG. 5 does not include Zn, and the In content is about 34 at%.

Referring to FIG. 5, even when the transistor according to Example Embodiment 1 is heat-treated at 500 °C, the threshold voltage is about -0.5 V. In this regard, the threshold voltage may refer to a minimum voltage when a current of 1E-10A/µm or more flows at the channel layer. The on/off current ratio is about 3.8E4. In this regard, the off current may be a current value at the threshold voltage, and the on current may be a current value at a voltage obtained by adding 1 V to the threshold voltage. When the channel layer does not include Zn and has an In content less than 50 at%, the channel may operate as a transistor even after being heat-treated at about 500 °C.

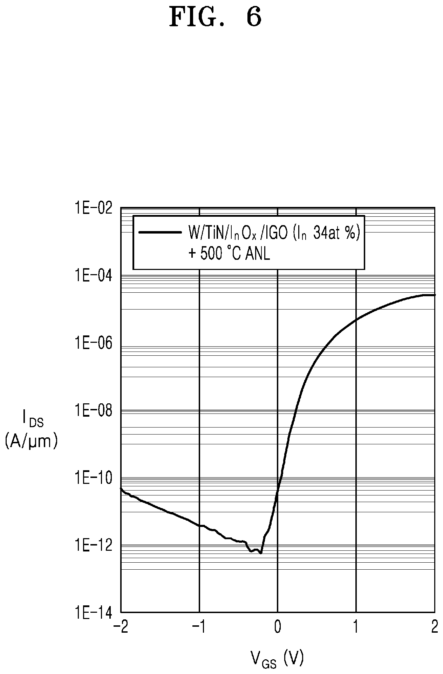

FIG. 6 illustrates a graph showing IV characteristics after performing heat treatment at 500 °C on a transistor including a channel layer formed of IGO (In 34 at%), an electrode formed of W, and a layer formed of InO and a metal nitride layer formed of TiN between the channel layer and the electrode, as Example Embodiment 2. The channel layer applied to FIG. 6 does not include Zn, and the In content is about 34 at%.

Referring to FIG. 6, even when the transistor according to Example Embodiment 2 is heat-treated at 500 °C, the threshold voltage is about -0.1 V. The on/off current ratio is about 5.6E6. The transistor according to Example Embodiment 2 which includes a metal nitride layer and an oxide layer had a greater threshold voltage than the transistor according to Example Embodiment 1, which does not include an oxide layer and a metal nitride layer, and has an improved on/off current ratio.

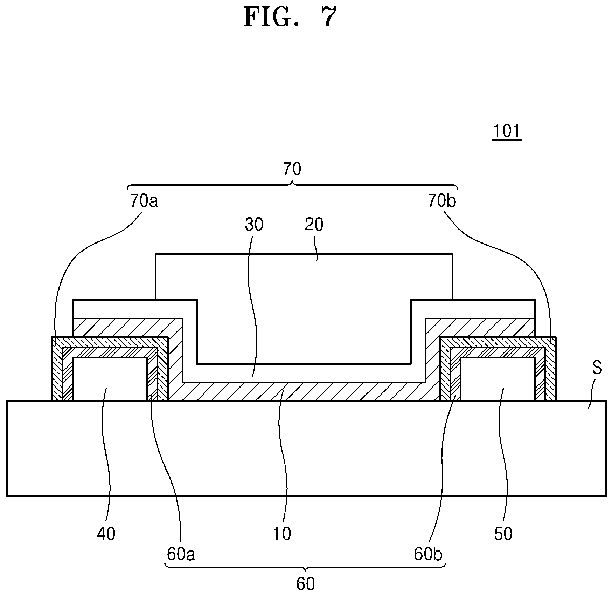

FIG. 7 is a diagram illustrating a semiconductor device 101 according to an example embodiment. The semiconductor device 101 of FIG. 7 may include an oxide semiconductor layer 10, a gate electrode 20 arranged apart from the oxide semiconductor layer 10, a gate insulating layer 30 arranged between the oxide semiconductor layer 10 and the gate electrode 20, and a first electrode 40 and a second electrode 50 which are arranged on the oxide semiconductor layer 10 and apart from the each other.

The oxide semiconductor layer 10 may correspond to the oxide semiconductor layer 11 described in relation to FIG. 1 or 2, and any redundant description thereof will be omitted.

The gate electrode 20 may be arranged apart from the oxide semiconductor layer 10. The gate insulating layer 30 may be arranged between the oxide semiconductor layer 10 and the gate electrode 20. The gate electrode 20 may include at least one of metal, metal nitride, and transparent conductive oxide (TCO). The gate insulating layer 30 may include an oxide including at least one of Hf, Zr, Al, and Si. When the semiconductor device 1 is a component of a memory cell, the gate electrode 20 may be a partial area of a word line.

The first electrode 40 and the second electrode 50 may be arranged apart from each other on the oxide semiconductor layer 11. For example, the first electrode 40 and the second electrode 50 may be arranged on a lower surface of the oxide semiconductor layer 10, and the gate electrode 20 may be arranged on an upper surface of the oxide semiconductor layer 10. However, example embodiments are not limited thereto. The first electrode 40, the second electrode 50, and the gate electrode 20 may also be arranged on the same surface of the oxide semiconductor layer 10. The first electrode 40 may be a source electrode, and the second electrode 50 may be a drain electrode. At least one of the first electrode 40 and the second electrode 50 may correspond to the metal layer 12 described in relation to FIG. 1, and thus specific description thereof will be omitted.

A metal nitride layer 60 may be further arranged between the oxide semiconductor layer 10 and at least one of the first electrode 40 and the second electrode 50. The metal nitride layer 60 may include a first metal nitride layer 60a arranged between the first electrode 40 and the oxide semiconductor layer 10 and a second metal nitride layer 60b arranged between the second electrode 50 and the oxide semiconductor layer 10. The first metal nitride layer 60a and the second metal nitride layer 60b may be arranged apart from each other. As the characteristics of the metal nitride layer 60 are described above in relation to FIG. 2, specific description thereof is omitted.

An oxide layer 70 may be further arranged between the oxide semiconductor layer 10 and the metal nitride layer 60. The oxide layer 70 may include a first oxide layer 70a arranged between the oxide semiconductor layer 10 and the first metal nitride layer 60a and a second oxide layer 70b arranged between the oxide semiconductor layer 10 and the second metal nitride layer 60b. As the characteristics of the oxide layer 70 are described above in relation to FIG. 2, specific description thereof is omitted. Although FIG. 7 illustrates that the metal nitride layer 60 and the oxide layer 70 are arranged between the first electrode 40 and the oxide semiconductor layer 10 and between the second electrode 50 and the oxide semiconductor layer 10, example embodiments are not limited thereto. In some example embodiments, the metal nitride layer 60 and the oxide layer 70 may be arranged at least one of between the first electrode 40 and the oxide semiconductor layer 10 and between the second electrode 50 and the oxide semiconductor layer 10. In some example embodiments, the metal nitride layer 60 and the oxide layer 70 may not be arranged between the first electrode 40 and the oxide semiconductor layer 10 and between the second electrode 50 and the oxide semiconductor layer 10.

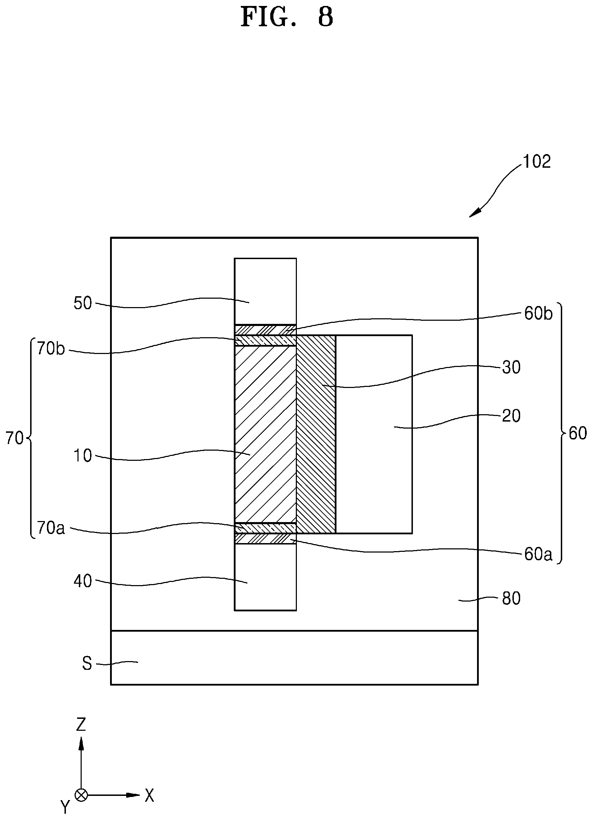

FIG. 8 is a diagram illustrating a semiconductor device 102 according to another example embodiment. Referring to FIG. 8, the semiconductor device 102 may include a substrate S, the first electrode 40 arranged on the substrate S, the oxide semiconductor layer 10 arranged on the first electrode 40, and the second electrode 50 arranged on the oxide semiconductor layer 10. The semiconductor device 102 may further include the first metal nitride layer 60a arranged between the first electrode 40 and the oxide semiconductor layer 10, the first oxide layer 70a arranged between the first metal nitride layer 60a and the oxide semiconductor layer 10, the second metal nitride layer 60b arranged between the second electrode 50 and the oxide semiconductor layer 10, and the second oxide layer 70b arranged between the second metal nitride layer 60b and the oxide semiconductor layer 10. As the materials of the oxide semiconductor layer 10, the gate electrode 20, the gate insulating layer 30, the first electrode 40, the second electrode 50, the first metal nitride layer 60a, the second metal nitride layer 60b, the first oxide layer 70a, and the second oxide layer 70b are described above, specific description thereof is omitted.

The oxide semiconductor layer 10 may be arranged in such a manner that a longitudinal direction thereof is a direction perpendicular to the substrate S (Z-axis direction). In the disclosure, the longitudinal direction may refer to a direction of a greater length of a component illustrated in the drawings.

The first electrode 40 and the second electrode 50 may be arranged apart from each other in a direction perpendicular to the substrate S (Z-axis direction). For example, the first electrode 40, the oxide semiconductor layer 10, and the second electrode 50 may be arranged in line in the direction perpendicular to the substrate S or the thickness direction of the first electrode 40 (Z-axis direction).

The gate electrode 20 may be arranged on one side of the oxide semiconductor layer 10. The gate insulating layer 30 may be arranged between the oxide semiconductor layer 10 and the gate electrode 20. The gate electrode 20 may be arranged in such a manner that the longitudinal direction thereof (Z-axis direction) is a direction perpendicular to the substrate S. The oxide semiconductor layer 10, the gate insulating layer 30, and the gate electrode 20 may be arranged in a line in a direction horizontal to the substrate S (X-axis direction).

An insulating layer 80 may be arranged on the substrate S to fill an empty space. The first electrode 40 may be arranged apart from the substrate S by the insulating layer 80.

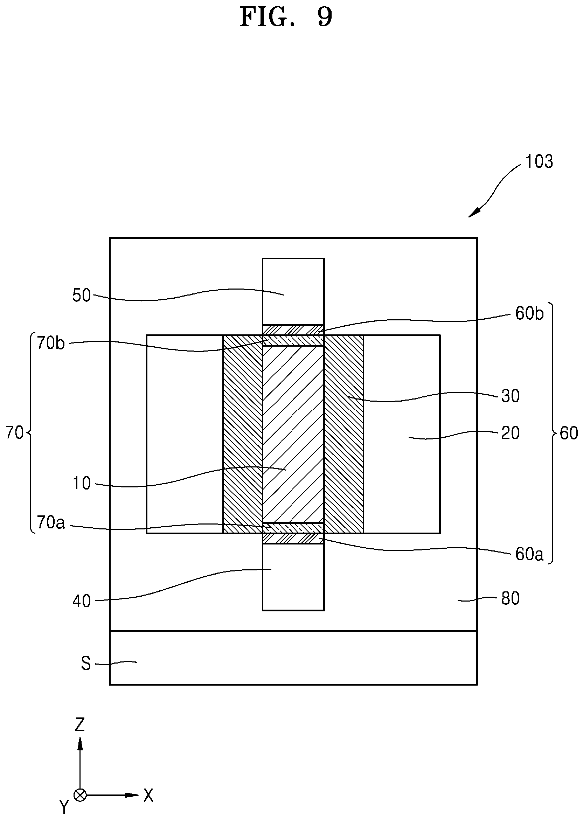

FIG. 9 is a diagram illustrating a semiconductor device 103 according to another example embodiment. In FIG. 9, components denoted by the same reference numerals as in FIG. 8 have substantially the same configuration and effects as described in relation to FIG. 8, and thus any redundant description will be omitted.

The semiconductor device 103 illustrated in FIG. 9 may include the first electrode 40, the oxide semiconductor layer 10, and the second electrode 50 which are arranged in the direction perpendicular to the substrate S (Z-axis direction). The gate insulating layer 30 may be arranged on a circumference of the oxide semiconductor layer 10, and the gate electrode 20 may be arranged on a circumference of the gate insulating layer 30. As the gate electrode 20 is arranged on the circumference of the oxide semiconductor layer 10, an area between the gate electrode 20 and the oxide semiconductor layer 10 which face each other may increase, and the short channel effect may be suppressed or reduced.

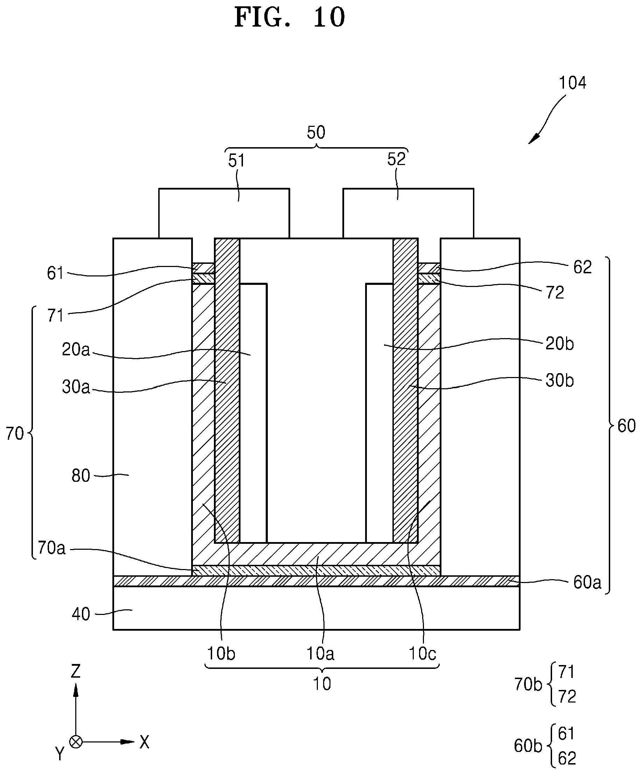

FIG. 10 is a diagram illustrating a semiconductor device 104 according to another example embodiment. In FIG. 10, components denoted by the same reference numerals as in the aforementioned drawings have substantially the same configuration and effects as described above, and thus any redundant description will be omitted.

The semiconductor device 104 illustrated in FIG. 10 may include the first electrode 40 and the oxide semiconductor layer 10 arranged on the first electrode 40. The first metal nitride layer 60a may be arranged between the first electrode 40 and the oxide semiconductor layer 10. The width of the first metal nitride layer 60a in a direction parallel to the surface of the first electrode 40 (e.g., X direction) may be greater than or equal to the width of the oxide semiconductor layer 10. For example, a partial area of the first metal nitride layer 60a may not overlap the oxide semiconductor layer 10 in the direction perpendicular to the surface of the first electrode 40 (e.g., Z direction).

In a cross-section view perpendicular to the surface of the first electrode 40, the oxide semiconductor layer 10 may include a first area extending in a direction parallel with the surface of the first electrode 40 and a second area extending in a direction from the first electrode 40 towards the second electrode 50. For example, the oxide semiconductor layer 10 may have a U-shaped cross-section. The oxide semiconductor layer 10 may include a bottom portion 10a in parallel with the surface of the first electrode 40, a first vertical extension 10b extending from one end of the bottom portion 10a in a direction perpendicular to the surface of the first electrode 40 (Z-axis direction), and a second vertical extension 10c extending from the other end of the bottom portion 10a in the direction perpendicular to the surface of the first electrode 40 (Z-axis direction).

The second electrode 50 may be arranged on the oxide semiconductor layer 10. The second electrode 50 may function as a landing pad. The second electrode 50 may include a first sub-electrode 51 and a second sub-electrode 52. The first sub-electrode 51 may be electrically connected to the first vertical extension 10b. The second sub-electrode 52 may be electrically connected to the second vertical extension 10c. The first sub-electrode 51 may not be electrically connected to the second sub-electrode 52.

In an example embodiment, an upper portion of each of the first sub-electrode 51 and the second sub-electrode 52 may have a first width in a first horizontal direction (X-axis direction), and a lower portion of each of the first sub-electrode 51 and the second sub-electrode 52 may have a second width in the first horizontal direction (X-axis direction), which is less than the first width. Each of the first sub-electrode 51 and the second sub-electrode 52 may have a t-shaped vertical cross-section.

A bottom surface of the lower portion of the first sub-electrode 51 may be arranged on an upper surface of the first vertical extension 10b, and a bottom surface of the lower portion of the second sub-electrode 52 may be arranged on an upper surface of the second vertical extension 10c. A bottom surface of the lower portion of the second electrode 50 may be arranged at a higher level than an upper surface of a first gate electrode 20a and/or a second gate electrode 20b, and a part of a side wall of the lower portion of the second electrode 50 may be covered by a first gate insulating layer 30a and/or a second gate insulating layer 30b.

The second metal nitride layer 60b may include a first sub-metal nitride layer 61 arranged between the first sub-electrode 51 and the first vertical extension 10b and a second sub-metal nitride layer 62 arranged between the second sub-electrode 52 and the second vertical extension 10c. The width of each of the first sub-metal nitride layer 61 and the second sub-metal nitride layer 62 may be less than the width of the upper portion of each of the first sub-electrode 51 and the second sub-electrode 52.

The second oxide layer 70b may include a first sub-oxide layer 71 arranged between the first sub-metal nitride layer 61 and a first vertical extension 10b and a second sub-oxide layer 72 arranged between the second sub-metal nitride layer 62 and a second vertical extension 10c.

The width of the first sub-oxide layer 71 may be identical to the width of the first vertical extension 10d, and the width of the second sub-oxide layer 72 may be identical to the width of the second vertical extension 10c.

The gate electrode 20 may include the first gate electrode 20a arranged apart from the first vertical extension 10b and the second gate electrode 20b arranged apart from the second vertical extension 10c. In addition, the gate insulating layer 30 may include the first gate insulating layer 30a arranged between the first vertical extension 10b and the first gate electrode 20a and the second gate insulating layer 30b arranged between the second vertical extension 10c and the second gate electrode 20b.

The first gate electrode 20a and/or the second gate electrode 20b may extend in a second horizontal direction (Y-axis direction). The first gate electrode 20a and the second gate electrode 20b may be arranged apart from each other.

The semiconductor device 104 may be a vertical channel transistor (VCT) structure including a vertical channel region extending in a direction perpendicular to the first electrode 40 (X-axis direction).

When the same electrical signal is applied to the first gate electrode 20a and the second gate electrode 20b, and the same electrical signal is applied to the first sub-electrode 51 and the second sub-electrode 52, the semiconductor device 104 may operate as a single transistor.

Alternatively, when electrical signals are independently applied to the first gate electrode 20a and the second gate electrode 20b, and electrical signals are independently applied to the first sub-electrode 51 and the second sub-electrode 52, the semiconductor device 104 may operate as two transistors. For example, the oxide semiconductor layer 10, the first gate electrode 20a, the first gate insulating layer 30a, the first electrode 40, the first sub-electrode 51, the first metal nitride layer 60a, the first oxide layer 70a, the first sub-metal nitride layer 61, and the first sub-oxide layer 71 may operate as one transistor, and the oxide semiconductor layer 10, the second gate electrode 20b, the second gate insulating layer 30b, the first electrode 40, the second sub-electrode 52, the second metal nitride layer 60b, the first oxide layer 70a, the second sub-metal nitride layer 62, and the second sub-oxide layer 72 may operate as another transistor.

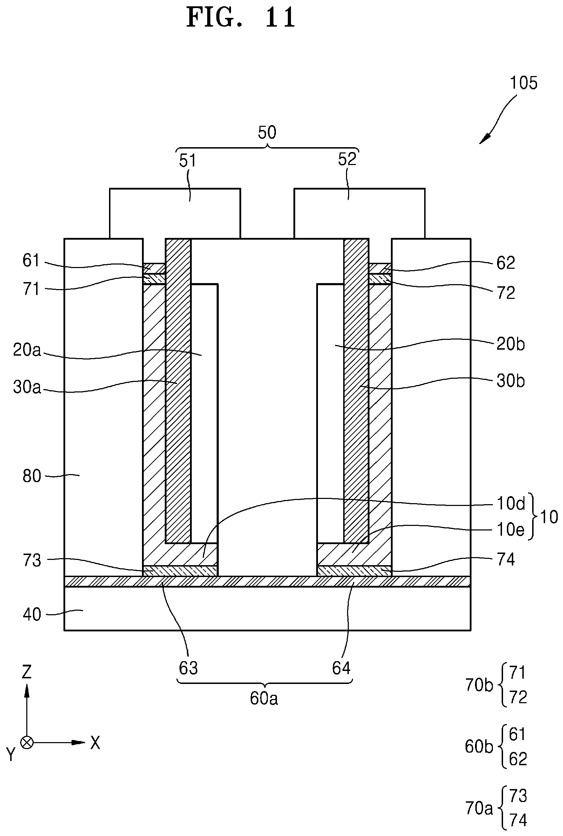

FIG. 11 is a diagram illustrating the semiconductor device 105 according to another example embodiment. As components in FIG. 11 that are denoted by the same reference numeral as in FIG. 10 have substantially the same configuration and operational effects, detailed descriptions thereon are omitted.

When comparing FIGS. 10 and 11, the shape of the oxide semiconductor layer 10 included in the semiconductor device 105 of FIG. 11 may be different from the shape of the oxide semiconductor layer 10 included in the semiconductor device 104 of FIG. 10. The semiconductor device 105 may include a first oxide semiconductor layer 10d and a second oxide semiconductor layer 10e. The first oxide semiconductor layer 10d may have an L-shape cross-section, and the second oxide semiconductor layer 10e may have a shape that is symmetrical with the first oxide semiconductor layer 10d with respect to the Z-axis direction. The first oxide semiconductor layer 10d and the second oxide semiconductor layer 10e may be separated from each other.

Each of the first oxide semiconductor layer 10d and the second oxide semiconductor layer 10e may be placed in a manner that a longitudinal direction thereof is arranged in a direction perpendicular to a substrate (not shown) (Z-axis direction).

The first metal nitride layer 60a may include a third sub-metal nitride layer 63 arranged between the first oxide semiconductor layer 10d and the first electrode 40 and a fourth sub-metal nitride layer 64 arranged between the second oxide semiconductor layer 10e and the second electrode 50. The third sub-metal nitride layer 63 and the fourth sub-metal nitride layer 64 may be in contact with each other and integrated (e.g., may be provided as an integral body).

The first oxide layer 70a may include a third sub-oxide layer 73 arranged between the third sub-metal nitride layer 63 and the first oxide semiconductor layer 10d and a fourth sub-oxide layer 74 arranged between the fourth sub-metal nitride layer 64 and the second oxide semiconductor layer 10e. The third sub-oxide layer 73 and the fourth sub-oxide layer 74 may be spaced apart from each other and may not be electrically connected to each other.

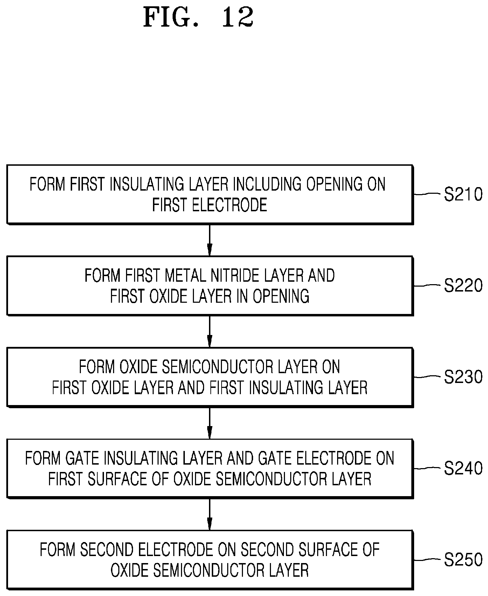

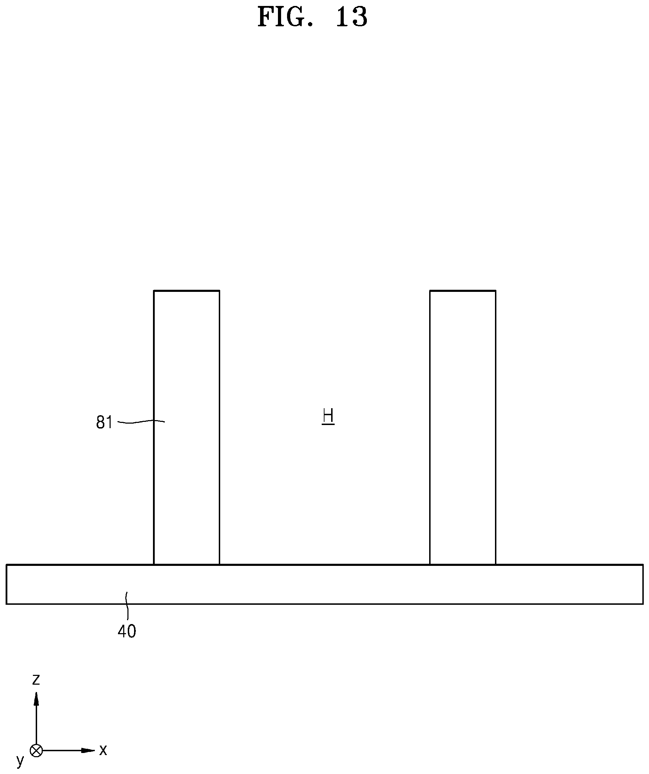

FIG. 12 is a flowchart of a method of manufacturing a semiconductor device, according to an example embodiment, and FIGS. 13 to 20 are cross-sectional views sequentially illustrating the method of manufacturing the semiconductor device of FIG. 10.

Referring to FIGS. 12 and 13, a first insulating layer 81 including an opening H partially exposing the electrode may be formed on the first electrode 40 (S210). A plurality of first insulating layers 81 extending in a second horizontal direction (Y-axis direction) may be deposited on the first electrode 40 extending in the first horizontal direction (X-axis direction). The first insulating layers 81 may be stacked in a vertical direction (Z-axis direction) to have a certain height.

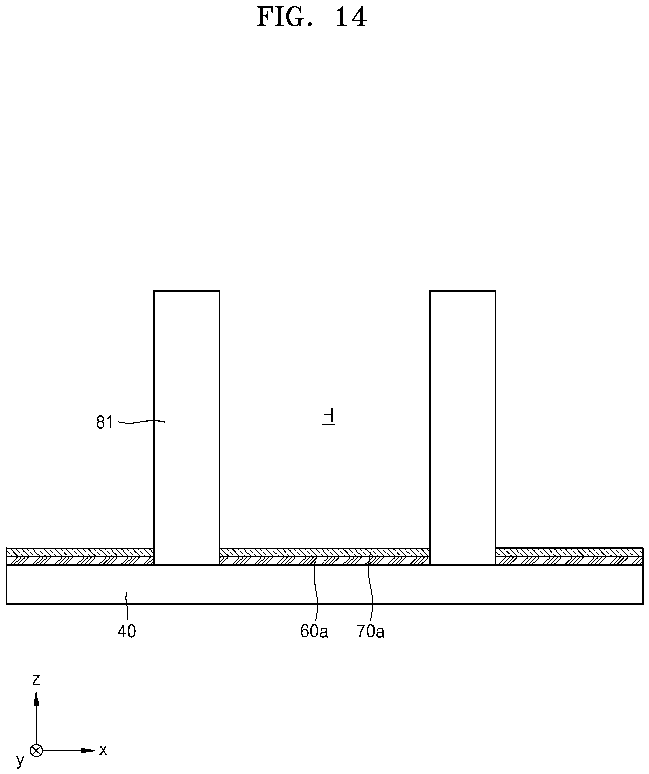

Referring to FIGS. 12 and 14, the first metal nitride layer 60a and the first oxide layer 70a may be sequentially formed on the first electrode 40 exposed by the opening H (S220). Each of the first metal nitride layer 60a and the first oxide layer 70a may be deposited by using a selective Atomic Layer Deposition (ALD) process or a Plasma-Enhanced Atomic Layer Deposition (PE-ALD) process. As the materials, thickness, etc. of the first metal nitride layer 60a and the first oxide layer 70a are described above, no further description thereof is provided.

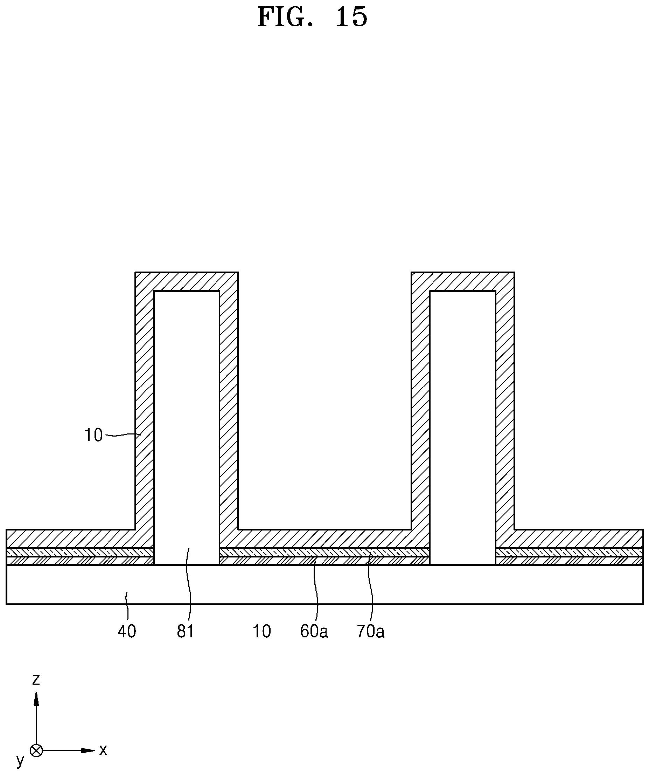

Referring to FIGS. 12 and 15, the oxide semiconductor layer 10 may be formed on the first oxide layer 70a and the first insulating layers 81 (S230). The oxide semiconductor layer 10 may be deposited by using the thermal-ALD method or the PE-ALD method. The oxide semiconductor layer 10 may have a U-shaped cross-section.

Referring to FIG. 12, the gate insulating layer (30a and 30b) and the gate electrode (20a and 20b) may be formed on the first surface of the oxide semiconductor layer 10 (S240).

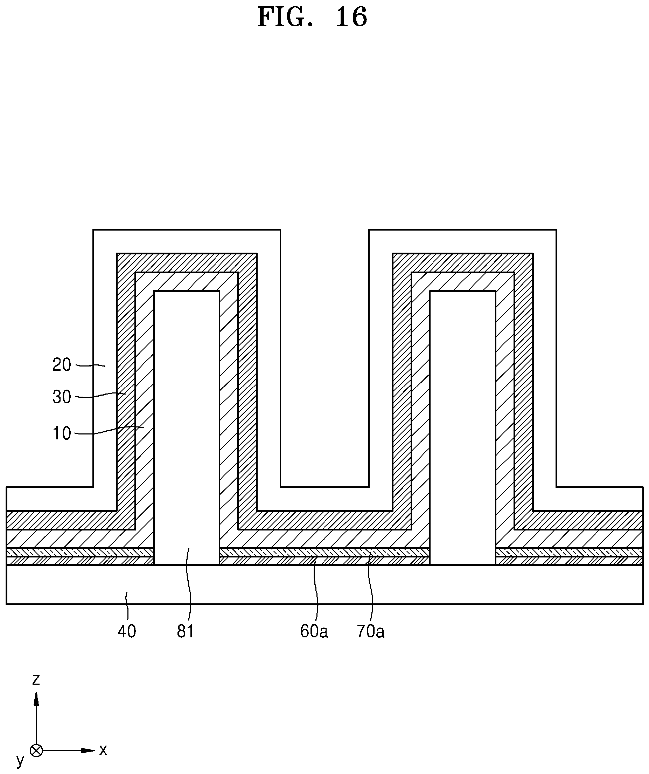

As illustrated in FIG. 16, the gate insulating layer 30 and the gate electrode 20 may be formed on the surface of the oxide semiconductor layer 10.

By partially etching the gate insulating layer 30 and the gate electrode 20 of the structure illustrated in FIG. 16, a partial surface of the oxide semiconductor 10, for example, a bottom portion 13 may be exposed. In addition, the gate electrode 20, the gate insulating layer 30, and the oxide semiconductor layer 10 may be etched in a direction to an upper portion of the first insulating layers 81 to expose upper surfaces of the first insulating layers 81. The height of each of the upper surface of the first insulating layers 81, the upper surfaces of the first gate electrode 20a and the second gate electrode 20b, and the upper surfaces of the first gate insulating layer 30a and the second gate insulating layer 30b with respect to the first electrode 40 may be identical to each other.

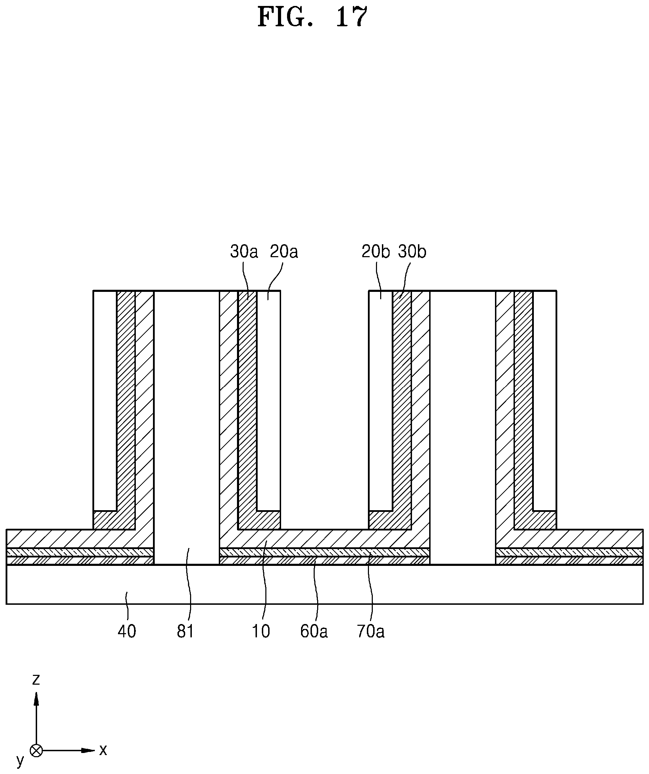

Thus, as illustrated in FIG. 17, the gate electrode 20 may be divided into the first gate electrode 20a and the second gate electrode 20b, and the gate insulating layer 30 may be divided into the first gate insulating layer 30a and the second gate insulating layer 30b.

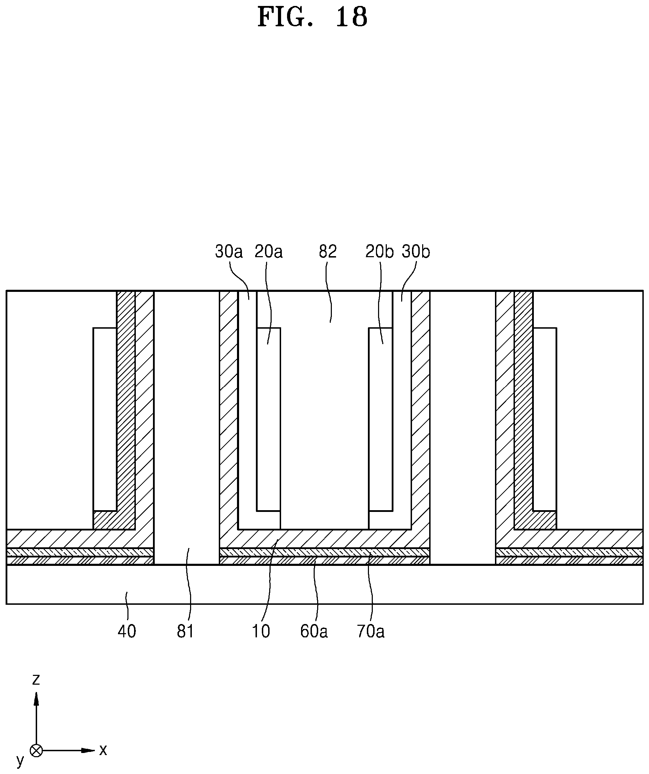

Referring to FIG. 18, by etching the first gate electrode 20a and the second gate electrode 20b once again, the heights of the upper surfaces of the first gate electrode 20a and the second gate electrode 20b with respect to the first electrode 40 may be lower than the heights of the upper surfaces of the first gate insulating layer 30a and the second gate insulating layer 30b.

The second insulating layer 82 may be deposited from the surface of the bottom portion 13 of the oxide semiconductor layer 10 to the same height as the upper surface of the oxide semiconductor layer 10. The height of the upper surface of the second insulating layer 82 may be identical to the height of the upper surface of the first insulating layers 81 and the height of the upper surface of the oxide semiconductor layer 10.

The second electrode 50 may be formed on a second surface different from the first surface of the oxide semiconductor layer 10 (S250).

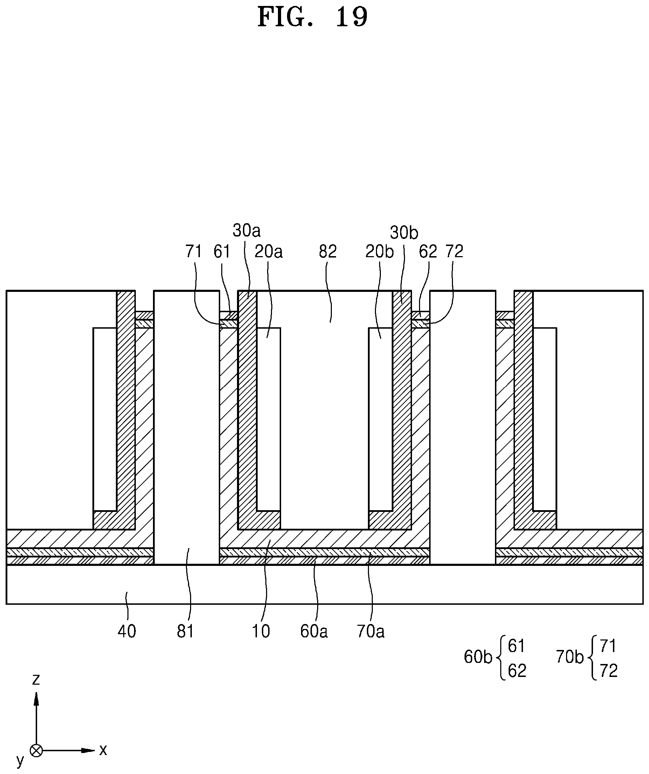

As illustrated in FIG. 19, the upper portion of the oxide semiconductor layer 10 may be partially etched, and the second oxide layer 70b and the second metal nitride layer 60b may be sequentially deposited on the etched oxide semiconductor layer 10.

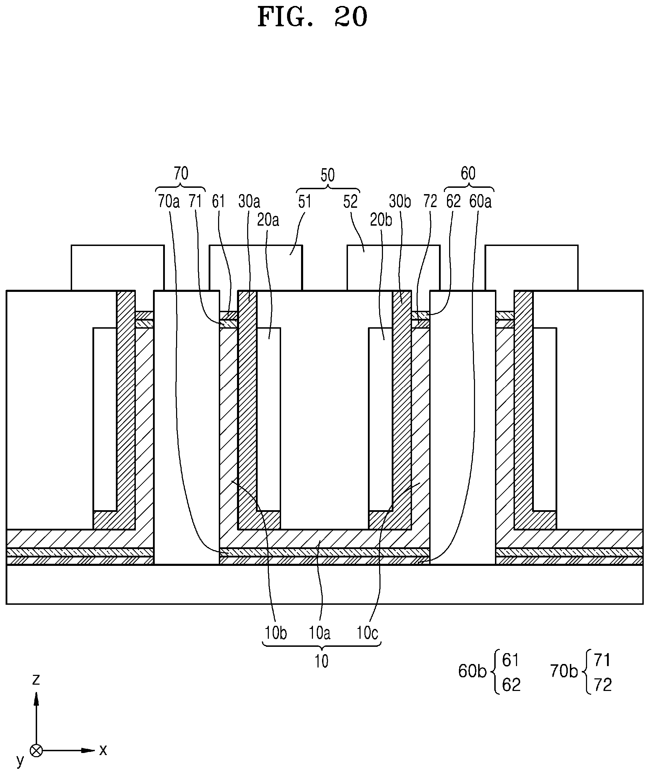

As illustrated in FIG. 20, the second electrode 50 may be deposited on the second metal nitride layer 60b. After depositing the metal layer on the second insulating layer 82, the first gate insulating layer 30a, the second gate insulating layer 30b, and the second metal nitride layer 60b, the metal layer may be etched to partially expose the first insulating layers 81 and the second insulating layer 82. In this manner, the second electrode 50 may be formed from the metal layer.

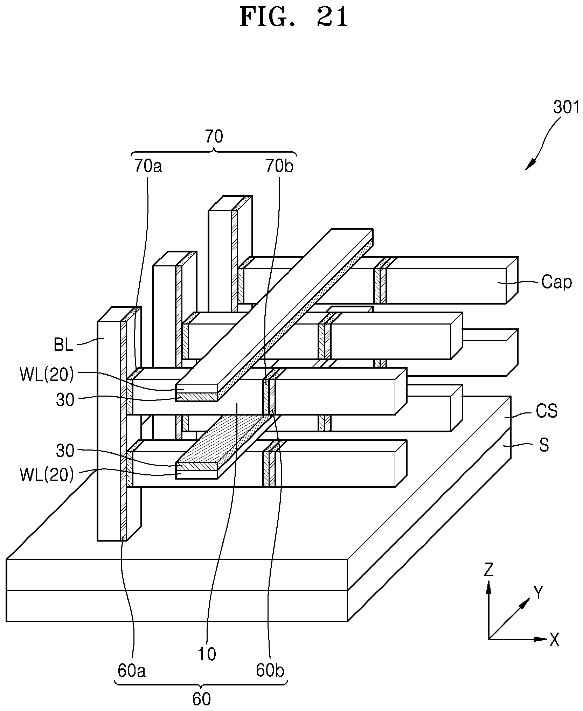

The semiconductor device according to an example embodiment may be a component of a memory device. FIG. 21 is a perspective view illustrating an example of a schematic structure of a vertically stacked memory device 301 according to an example embodiment. Referring to FIG. 21, the vertically stacked memory device 301 may include a plurality of bit lines BL extending in the first direction (Z direction), a plurality of oxide semiconductor layers 10 connected to the plurality of bit lines BL, respectively, and extending in a second direction (X direction) vertically intersecting with the first direction, a plurality of capacitors Cap electrically connected to the plurality of oxide semiconductor layers 10, respectively, and a plurality of word lines WL extending to intersect with the plurality of oxide semiconductor layers 10 in the third direction (Y direction) vertically intersecting with the first direction and the second direction. Although FIG. 21 illustrates that each of the plurality of word lines WL crosses on a corresponding oxide semiconductor layer 10 of the plurality of oxide semiconductor layers 10, example embodiments are not limited thereto. In some example embodiments, the word lines WL may cross under the oxide semiconductor layers 10.

In addition, the vertically stacked memory device 301 may further include the substrate S for growth and a driving circuit board CS arranged on the substrate S for growth. The driving circuit board CS may include circuits for performing input/output operations for receiving data input from an external circuit connected thereto or outputting data to the outside and for performing operations for recording data on the capacitors Cap or reading data recorded on the capacitors Cap.

The plurality of bit lines BL may be arranged to be perpendicular to the upper surface of the driving circuit board CS on the driving circuit board CS. Although FIG. 21 illustrates that only three bit lines BL are arranged in line and apart from each other in the third direction (e.g., Y direction), a larger number of bit lines BL may be arranged in a 2D manner. For example, the plurality of bit lines BL extending in the vertical direction (e.g., the first direction) may be arranged in a 2D manner on the driving circuit board CS and spaced apart from each other in the second direction and the third direction. The plurality of bit lines BL may be arranged in parallel with each other.

The plurality of oxide semiconductor layers 10 connected to corresponding ones of the plurality of bit lines BL, respectively, may be spaced apart from each other in the first direction. Although FIG. 21 illustrates only two oxide semiconductor layers 10 in relation to one bit line BL, a larger number of oxide semiconductor layers 10 may be spaced apart from each other in the first direction. In addition, in the same layer, a plurality of oxide semiconductor layers 10 may be spaced apart from each other in third direction in parallel manner. The plurality of oxide semiconductor layers 10 arranged in the same layer may be connected to corresponding bit lines from among the plurality of bit lines BL, respectively. Similar to the plurality of bit lines BL, the plurality of oxide semiconductor layers 10 may be spaced apart from each other in the second direction and the third direction in a 2D manner. Each of the plurality of oxide semiconductor layers 10 may extend in the second direction. A first end of each of the plurality of oxide semiconductor layers 10 may be electrically connected on a corresponding bit line from among the plurality of bit lines BL. A second end of each of the plurality of oxide semiconductor layers 10, which is opposite to the first end, may be electrically connected to the capacitor Cap.

The first metal nitride layer 60a may be arranged between the oxide semiconductor layer 10 and the bit line BL, and the first oxide layer 70a may be arranged between the oxide semiconductor layer 10 and the first metal nitride layer 60a. In addition, the second metal nitride layer 60b may be arranged between the oxide semiconductor layer 10 and the capacitor, and the second oxide layer 70b may be arranged between the oxide semiconductor layer 10 and the second metal nitride layer 60b. Although the drawings illustrate that a pair of the metal nitride layer 60 and the oxide layer 70 are arranged at each end of the oxide semiconductor layer 10, example embodiments are not limited thereto. The metal nitride layer 60 and the oxide layer 70 may be arranged only at one end of the oxide semiconductor layer 10.

Although FIG. 21 illustrates the capacitor Cap as one block, the capacitor Cap may include a first electrode, a second electrode, and a dielectric layer arranged between the first electrode and the second electrode. The first electrode of the capacitor Cap may be electrically connected to the second electrode of the corresponding oxide semiconductor layer 10 from among the plurality of oxide semiconductor layers 10. Accordingly, one oxide semiconductor layer 10 may be connected to one capacitor Cap. Although it is not shown in the drawings, the second electrode 50 of the capacitor Cap may be connected to a ground line of the vertically stacked memory device.

The word line WL may extend in the third direction to cross on the plurality of corresponding oxide semiconductor layers 10. The plurality of word lines WL may be spaced apart from each other in the first direction. Although FIG. 21 illustrates only one word line WL arranged on one layer, a plurality of word lines WL may be spaced apart from each other in the second direction on one layer in a parallel manner.

The gate insulating layer 30 may be arranged between the oxide semiconductor layer 10 and the word line WL. Although it is not shown in FIG. 21, a vertically stacked memory device 301 may further include an insulating material filled in spaces between the plurality of bit lines BL, between the plurality of oxide semiconductor layers 10, and between the plurality of word lines WL.

One oxide semiconductor layer 10 may form one oxide semiconductor transistor together with one corresponding word line WL, one corresponding bit line BL, and the first electrode of the capacitor. The first electrode 40 of the oxide semiconductor transistor may be a component of the bit line BL, the gate electrode 20 may be a component of the word line WL, and the second electrode 50 may be the first electrode of the capacitor Cap. However, example embodiments are not limited thereto. The first electrode 40, the gate electrode 20, and the second electrode 50 may be provided as separate layers and may be electrically connected to a bit line BL, the word line WL, and the capacitor Cap, respectively

As the word line WL may function as the gate electrode 20 of the oxide semiconductor transistor, when a gate signal greater than a threshold value is applied to the word line WL, a current may flow along the oxide semiconductor layer 10. In this manner, the corresponding bit line BL and the capacitor Cap may be electrically connected to each other, and accordingly, data may be recorded to the capacitor Cap, or data recorded to the capacitor Cap may be read.

As such, one oxide semiconductor layer 10 and one capacitor Cap corresponding thereto may form a memory cell. A vertically stacked memory device 301 according to an example embodiment may include a plurality of memory cells arranged in a 2D manner on one layer. The vertically stacked memory device 201 may have a structure in which a plurality of layers including a plurality of memory cells arranged in a 2D manner are stacked. Accordingly, the degree of integration of the memory cells may be increased, thereby improving recording capacity of the vertically stacked memory device 301.

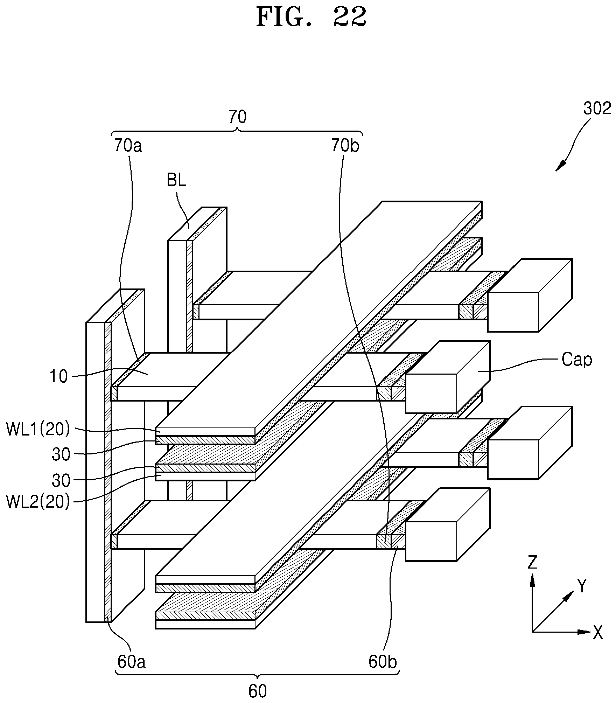

FIG. 22 is a perspective view illustrating an example of a schematic structure of a vertically stacked memory device 302 according to another example embodiment. Referring to FIGS. 21 and 22, the vertically stacked memory device 302 of FIG. 22 may have a double gate structure. For example, the vertically stacked memory device 302 may include a first word line WL1 extending in the third direction to cross on the plurality of oxide semiconductor layers 10 arranged at the same layer and a second word line WL2 extending in the third direction to cross under the plurality of oxide semiconductor layers 10 arranged at the same layer. The first word line WL1 and the second word line WL2 may be arranged apart from each other in the first direction with the corresponding oxide semiconductor layer 10 arranged therebetween and may face each other in a parallel manner. In other words, each of the plurality of word lines WL illustrated in FIG. 22 may include the first word line WL1 and the second word line WL2 which are arranged to face each other in a parallel manner and apart from each other in the first direction with the corresponding oxide semiconductor layer 10 arranged therebetween from among the plurality of oxide semiconductor layers 10.

One oxide semiconductor layer 10 may form one oxide semiconductor transistor together with a corresponding pair of the first word line WL1 and the second word line WL2. Operations of the oxide semiconductor transistor may be controlled by the first word line WL1 arranged on the oxide semiconductor layer 10 and the second word line WL2 arranged under the oxide semiconductor layer 10. Accordingly, the driving reliability of the oxide semiconductor transistor may be improved. As other components of a vertically stacked memory device 302 illustrated in FIG. 22 may be the same as the structures of the vertically stacked memory device 301 illustrated in FIG. 21, any redundant description thereof is omitted.

Although FIGS. 21 and 22 illustrate that the bit lines BL are arranged perpendicular to the upper surface of the driving circuit board CS, and the word lines WL are arranged horizontal with the upper surface of the driving circuit board CS, example embodiments are not limited thereto. The bit lines BL may be arranged horizontal with the upper surface of the driving circuit board CS, and the word lines WL may be arranged perpendicular to the upper surface of the driving circuit board CS. That is, the oxide semiconductor layer 10 and the capacitor Cap may be sequentially arranged from the driving circuit board CS.

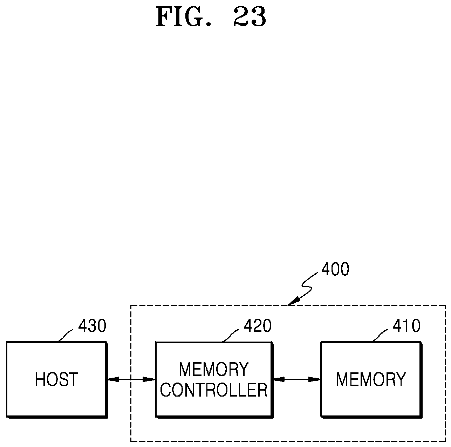

FIG. 23 is a block diagram illustrating an electronic system 400 according to an example embodiment.

The electronic system 400 may include a memory 410 and a memory controller 420. The memory controller 420 may control the memory 410 to read data from the memory 410 and/or write data on the memory 410 in response to a request from a host 430. At least one of the memory 410 and the memory controller 420 may include the semiconductor device 1 according to an example embodiment.

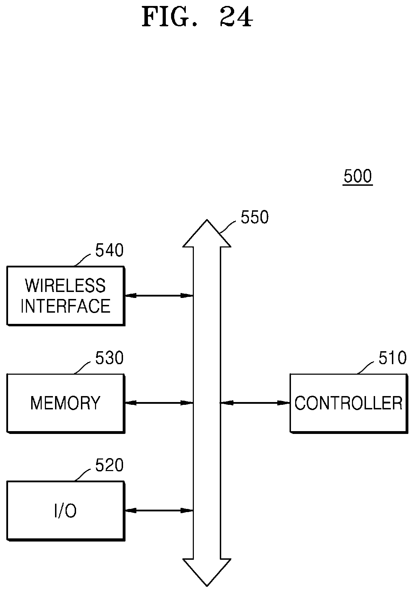

FIG. 24 is a block diagram illustrating an electronic system 500 according to an example embodiment.

The electronic system 500 may constitute a wireless communication device or a device configured to transmit and/or receive information under a wireless environment. The electronic system 500 may include a controller 510, an input/output (I/O) device 520, a memory 530, and a wireless interface 540, which are connected to each other through a bus 550.

The controller 510 may include at least one of a microprocessor, a digital signal processor, and any other similar processors. The I/O device 520 may include at least one of a keypad, a keyboard, and a display. The memory 530 may be used to store instructions performed by the controller 510. For example, the memory 530 may be used to store user data. The electronic system 500 may use the wireless interface 540 to transmit/receive data through a wireless communication network. The wireless interface 540 may include an antenna and/or a wireless transceiver. The electronic system 400 may include the semiconductor device according to an example embodiment.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

The lower In content of the channel layer of the semiconductor device according to an example embodiment may improve thermal stability of the semiconductor device.

As the semiconductor device according to an example embodiment includes the metal nitride layer between the channel layer and the electrode, diffusion of the material of the channel layer to the electrode may be reduced or prevented.

As the semiconductor device according to an example embodiment includes the oxide layer having a dominant In content between the channel layer and the electrode, the contact resistance between the channel layer and the electrode may be reduced.

It should be understood that some example embodiments described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. A semiconductor device comprising:
an oxide semiconductor layer including a plurality of metals, wherein, with respect to the plurality of metals, a content of indium (In) is less than 50 at%, and a content of zinc (Zn) is 0 at%;
a gate electrode being apart from the oxide semiconductor layer;
a gate insulating layer being between the oxide semiconductor layer and the gate electrode; and
a first electrode and a second electrode on the oxide semiconductor layer and being from each other with the gate electrode interposed therebetween.

2. The semiconductor device of claim 1, wherein the oxide semiconductor layer further includes at least one of gallium (Ga), tin (Sn), cadmium (Cd), aluminum (Al), germanium (Ge), and hafnium (Hf).

3. The semiconductor device of claim 1 or 2, wherein the content of indium (In) with respect to the plurality of metals is 10 at% or more.

4. The semiconductor device of any preceding claim, wherein
the oxide semiconductor layer further includes gallium (Ga), and
a content of gallium (Ga) is greater than the content of indium (In).

5. The semiconductor device of any preceding claim, wherein the oxide semiconductor layer includes only InGaO, and a content of gallium (Ga) is 50 at% or more.

6. The semiconductor device of any preceding claim, wherein the oxide semiconductor layer maintains an amorphous phase at a temperature from 450 °C to 700 °C.

7. The semiconductor device of any preceding claim, wherein the first electrode, the oxide semiconductor layer, and the second electrode are in sequence in a direction perpendicular to a surface of the first electrode, and optionally wherein the oxide semiconductor layer includes, in a cross-sectional view perpendicular to the surface of the first electrode, a first area extending in a direction parallel with the surface of the first electrode and a second area extending from the first electrode towards the second electrode.

8. The semiconductor device of any preceding claim, further comprising:
a capacitor electrically connected to the oxide semiconductor layer,
wherein the first electrode is a component of a bit line, and the gate electrode is a component of a word line.

9. The semiconductor device of any preceding claim, further comprising:
a metal nitride layer being between the oxide semiconductor layer and at least one of the first electrode and the second electrode; and
an oxide layer being between the metal nitride layer and the oxide semiconductor layer, the oxide layer being an indium (In) based oxide layer, and optionally wherein the metal nitride layer is in direct contact with at least one of the first electrode and the second electrode.

10. The semiconductor device of claim 9, wherein the oxide layer is in direct contact with at least one of the oxide semiconductor layer and the metal nitride layer.

11. The semiconductor device of claim 9 or 10, wherein the oxide layer includes indium (In), and a content of indium (In) with respect to a plurality of metals included in the oxide layer is 50 at% or more.

12. The semiconductor device of any of claims 9 to 11, wherein the metal nitride layer includes metal different from a first metal included in the first electrode, a second metal included in a second electrode, and the plurality of metals included in the oxide semiconductor layer.

13. The semiconductor device of any of claims 9 to 12, wherein the metal nitride layer includes at least one of titanium (Ti), molybdenum (Mo), niobium (Nb), and tantalum (Ta).

14. A method of manufacturing a semiconductor device, the method comprising:
forming a first insulating layer on a first electrode, the first insulating layer including an opening exposing the first electrode;
sequentially forming a first metal nitride layer and a first oxide layer on the first electrode exposed by the opening;
forming an oxide semiconductor layer on the first oxide layer and the first insulating layer, the oxide semiconductor layer including a plurality of metals, wherein, with respect to the plurality of metals, a content of indium (In) is less than 50 at%, and a content of zinc (Zn) is 0 at%;
sequentially forming a gate insulating layer and a gate electrode on a first surface of the oxide semiconductor layer; and
forming a second electrode on a second surface of the oxide semiconductor layer, which is different from the first surface of the oxide semiconductor layer.

15. The method of claim 14, wherein the forming of the gate insulating layer and the gate electrode comprises:
etching the gate insulating layer and the gate electrode in a direction to an upper portion of the first insulating layer to expose a surface of the oxide semiconductor layer such that the gate insulating layer is divided into a first gate insulating layer and a second gate insulating layer and the gate electrode is divided into a first gate electrode and a second gate electrode, surface of the oxide semiconductor layer being parallel with the surface of the first electrode; and
partially etching the first gate electrode and the second gate electrode such that heights of upper surfaces of the first gate electrode and the second electrode from the first electrode are lower than heights of upper surfaces of the first gate insulating layer and the second gate insulating layer from the first electrode, respectively.
